# EUROPEAN PATENT APPLICATION

(11) **EP 2 624 305 A1**
(43) Date of publication of application: **07.08.2013**
(21) Application number: 10857657.0
(22) Date of filing: 27.09.2010
(51) Int. Cl.: H01L 31/04, H01L 51/30

(54) **COUNTER ELECTRODE FOR DYE-SENSITIZED SOLAR CELL AND MANUFACTURING METHOD THEREOF**

(71) Applicant: Ocean's King Lighting Science&Technology Co., Ltd., Guangdong 518054 (CN)
(72) Inventor: ZHOU, Mingjie, Guangdong 518054 (CN); WANG, Ping, Guangdong 518054 (CN); HUANG, Hui, Guangdong 518054 (CN); CHEN, Jixing, Guangdong 518054 (CN)
(74) Representative: Brunetti, Fabrizio
(86) International application number: PCT/CN2010/077366
(87) International publication number: WO 2012/040894

(57) **Abstract**

The invention relates to a counter electrode for a dye-sensitized solar cell and a manufacturing method thereof. The counter electrode comprises a conductive substrate and an acid doped polyaniline layer coated on at least one surface of the conductive substrate. The conductivity of the counter electrode is increased, the recombination probability of I₃⁻ and a conduction band electron is decreased, the bond strength of the acid doped polyaniline layer and the conductive substrate is enhanced, the electronic transmission rate and the conductivity of the counter electrode for the external circuit are further increased, and the production cost is reduced. The manufacturing method can simplify the production process, produce the stable performance counter electrode, increase the production efficiency, and reduce the requirement for production equipment, thus suitable for industrial production.

## Description

### Technical Field

The present invention belongs to the technical field of solar cells, and particularly relates to a counter electrode for dye-sensitized solar cell and a method for manufacturing the same.

### Background

Since 1980s, dye-sensitized solar cells have drawn great attention from researchers. In 1991, Professor M. Gratzel and his research group from École polytechnique fédérale de Lausanne, Switzerland, made a great breakthrough in the research in dye sensitization of porous electrode. They assembled a new type of solar cell, a dye-sensitized solar cell, using a porous titanium dioxide (TiO₂) film electrode, which is sensitized by an organic complex dye comprising a transition metal ruthenium as a photosensitizer, as the photoanode, iodine and lithium iodide as the electrolyte, and a platinum electrode as the counter electrode, and obtained a photoelectric conversion efficiency of 7.1% - 7.9% under the radiation of simulated sunlight of AM 1.5 and 100 mW/cm². In 1993, M. Gratzel et al. further reported a dye-sensitized nanometer solar cell having a photoelectric conversion efficiency of up to 10%. In 1997, the photoelectric conversion efficiency was further increased to 10-11%, and the short-circuit current was 18 mA/cm², and the open-circuit voltage was 720 mV. Since then, dye-sensitized solar cells have drawn great attention worldwide.

A dye-sensitized solar cell mainly consists of a transparent conductive substrate, a porous nanocrystalline film, a sensitizer, an electrolyte (I⁻/I3⁻ ) solution and a transparent counter electrode. The photoelectric conversion mechanism thereof is as follows. When sunlight reaches the cell, the dye molecules absorb energy from sunlight, and electrons in the dye molecules are excited and transit to an excited state. The electrons in the excited state would be rapidly injected into the TiO₂ conductive band, and the dye molecules are transformed to an oxidized state due to loss of the electrons. The electrons injected into the TiO₂ conductive band are transmitted rapidly in the TiO₂ film, instantly reach the contact interface between the film and the conductive glass, accumulate on the conductive substrate, and flow to the counter electrode through an outer circuit. The dye molecules in the oxidized state accept electrons from the electron donor (I⁻) in the electrolyte (I⁻/I₃⁻) solution and return to the ground state, thereby regenerating the dye molecules. After losing its electron, the electron donor (reductant) in the electrolyte solution diffuses to the counter electrode and accepts an electron and is reduced. In this way, a photoelectric chemical reaction cycle is completed. The counter electrode is mainly used for collecting electrons, accelerating the electron exchange rate between I⁻/I₃⁻ and cathode electrons, and decreasing to the greatest extent the probability of the recombination between I₃⁻ and electrons in the TiO₂ conductive band. However, the currently used counter electrodes are mainly those using platinum as the surface plating. Although this kind of counter electrodes has good catalytic capability, platinum itself is an expensive rare material and the manufacturing process thereof is complex, leading to high production cost of this kind of counter electrodes, which is not suitable for large scale production and application. Accordingly, it has become a trend in the art to develop new materials for counter electrodes which exhibit low cost and high efficacy and can be used to replace platinum electrodes.

### Summary

The embodiments of the present inventions provide a counter electrode for dye-sensitized solar cell which shows high conductivity and low cost.

In addition, a method for preparing a counter electrode for dye-sensitized solar cell is provided.

In order to achieve the above objectives, the technical solutions of the present invention are as follows.

A counter electrode for dye-sensitized solar cell comprises a conductive substrate and an acid-doped polyaniline layer coated on at least one surface of the conductive substrate.

In addition, a method for preparing a counter electrode for dye-sensitized solar cell comprises the steps of:
providing an acid-doped polyaniline solution and a conductive substrate; and
coating the acid-doped polyaniline solution on at least one surface of the conductive substrate, and drying to give the counter electrode for dye-sensitized solar cell having an acid-doped polyaniline layer coated on a surface thereof.

The counter electrode for dye-sensitized solar cell according to the present invention comprises an acid-doped polyaniline layer. The acid-doped polyaniline in the acid-doped polyaniline layer has a relatively high conductivity, leading to low surface resistance of the counter electrode and high conductivity of the counter electrode. The acid-doped polyaniline has a strong catalytic capability, which increases the probability of redox reaction between I₃⁻ in the electrolyte of the dye-sensitized solar cell comprising the counter electrode with electrons in the outer circuit, thereby decreasing to the greatest extent the probability of the recombination between I₃⁻ and electrons in the conductive band. The acid-doped polyaniline has a relatively high viscosity, which increases the binding strength between the acid-doped polyaniline layer and the conductive substrate, thereby further increasing the electron transmission rate from the counter electrode to the outer circuit as well as the conductivity. The counter electrode for dye-sensitized solar cell has a performance which is comparative with that of currently used platinum counter electrodes, and has low production cost. The method for preparing the counter electrode for dye-sensitized solar cell is simple, and the obtained counter electrode for dye-sensitized solar cell has a stable performance. The method exhibits high production efficiency, has low requirements on the production equipments, and is suitable for industrial production.

### Brief Description of the Figures

Figure 1 shows a scheme of a structure of the counter electrode for dye-sensitized solar cell according to the present invention;
Figure 2 shows a scheme of another structure of the counter electrode for dye-sensitized solar cell according to the present invention; and
Figure 3 shows a scheme of the flow chart of the method for preparing the counter electrode for dye-sensitized solar cell according to the present invention.

### Specific Embodiments of the Present Invention

In order to make the technical problems to be solved, the technical solutions and the advantages of the present invention more obvious, the present invention will be further described in detail in combination with the Figures and the embodiments. It shall be understood that the specific embodiments described herein are only to illustrate rather than to limit the present invention.

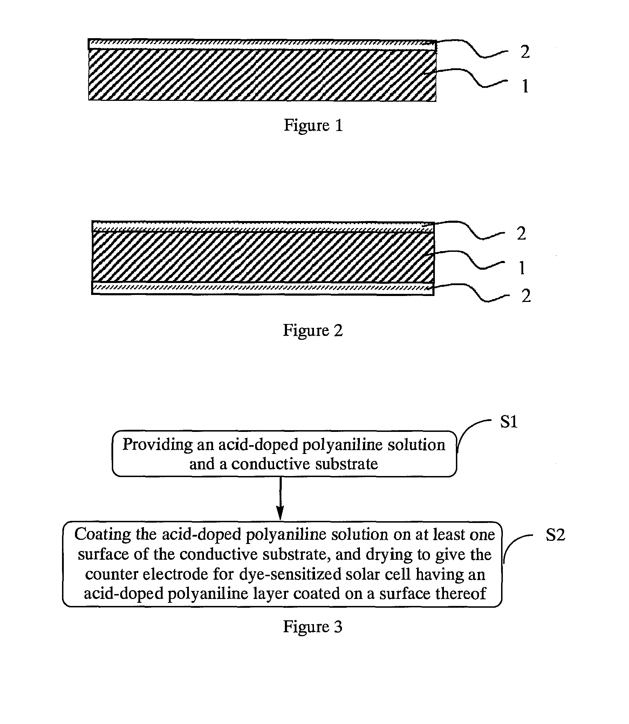

An embodiment of the present invention provides a counter electrode for dye-sensitized solar cell which shows high conductivity and low cost. The structures thereof are illustrated in Figures 1 and 2. The counter electrode for dye-sensitized solar cell of the present embodiment comprises a conductive substrate 1 and an acid-doped polyaniline layer 20 coated on at least one surface of the conductive substrate 1. In this way, the counter electrode for dye-sensitized solar cell of the present embodiment comprises an acid-doped polyaniline layer, which comprises an acid-doped polyaniline having relatively high conductivity, leading to low surface resistance of the counter electrode, and increasing the conductivity of the counter electrode. The acid-doped polyaniline has strong catalytic ability, leading to increased probability of redox reaction between I₃⁻ in the electrolyte of the dye-sensitized solar cell comprising the counter electrode with electrons in the outer circuit, thereby decreasing to the greatest extent the probability of the recombination between I₃⁻ and electrons in the conductive band. The acid-doped polyaniline has a relatively high viscosity, which increases the binding strength between the acid-doped polyaniline layer and the conductive substrate, thereby further increasing the electron transmission rate from the counter electrode to the outer circuit as well as the conductivity. The counter electrode for dye-sensitized solar cell has a performance which is comparative with that of currently used platinum counter electrodes, and has low production cost.

Specifically, the counter electrode for dye-sensitized solar cell of the above embodiment can be implemented in at least two ways as shown below.

The first way is shown in Figure 1, wherein the counter electrode for dye-sensitized solar cell comprises a conductive substrate 1 and an acid-doped polyaniline layer 2 coated on one surface of the conductive substrate 1.

The second way is shown in Figure 2, wherein the counter electrode for dye-sensitized solar cell comprises a conductive substrate 1 and acid-doped polyaniline layers 2 coated on two opposite surfaces of the conductive substrate 1. In this way, by coating acid-doped polyaniline layers 2 on two opposite surfaces of the conductive substrate 1, the conductivity of the counter electrode for dye-sensitized solar cell is further improved, the probability of the recombination between I₃⁻ in the electrolyte of the dye-sensitized solar cell comprising the counter electrode and electrons in the conductive band is decreased to the greatest extent, and the electron transmission rate from the counter electrode to the outer circuit as well as the conductivity are further increased.

Furthermore, the thickness of the acid-doped polyaniline layer in the above embodiment is preferably 20 nm - 5 µm, more preferably 20 nm - 50 nm. The thickness of the acid-doped polyaniline layer has certain effects on the photoelectric conversion efficiency of the dye-sensitized solar cell. When the acid-doped polyaniline layer has a thickness in the above preferred range, the photoelectric conversion efficiency of the dye-sensitized solar cell can be effectively improved.

Specifically, the acid in the above acid-doped polyaniline layer is preferably a protonic acid. The protonic acid may be an organic protonic acid or an inorganic protonic acid. The protonic acid is preferably an organic functional protonic acid, more preferably a sulfonic acid and/or citric acid. The sulfonic acid is preferably at least one of camphorsulfonic acid, dodecylsulfonic acid, sulfosalicylic acid, p-styrene sulfonic acid, naphthalenesulfonic acid, dinonylnaphthalenesulfonic acid, dioctyl sulfosuccinate and sulfanilic acid. The inorganic protonic acid is preferably least one of hydrochloric acid, sulfuric acid and perchloric acid. The protonic acid is preferred because protonation preferably occurs on the amine nitrogen atom in the molecular chain, wherein the protonic acid HA dissociates and the resulted hydrogen proton (H+) transfers to the polyaniline molecular chain and protonates the amine nitrogen atom in the molecular chain to give excited state polarons of charge-carrying elements. After being doped with a protonic acid, the quinone ring in the eigen state polyaniline disappears, the electron cloud redistributes, and the positive charge on the nitrogen atom delocalizes to the conjugated π bonds, so that polyaniline exhibits high conductivity. Of course, the acid may also be selected from non-protonic acids, such as PCl₅, SOCl₂, TsCl and/or AlCl₃. The acid-doped polyaniline obtained by doping with a non-protonic acid has lower conductivity than that of the acid-doped polyaniline obtained by doping with a protonic acid. The acid-doped polyaniline layer is prepared with the following S12 process from eigen state polyaniline and an acid which are mixed in a mass ratio of preferably 1:2-1:5.

The material for the above conductive substrate 1 may be one of indium-doped tin oxide glass, fluorine-doped tin oxide glass, carbon steel, stainless steel, aluminum-doped zinc oxide, magnesium-indium oxide, nickel-tungsten oxide, metal nitride, metal selenide, metal sulfides, foamed copper, foamed aluminum, foamed copper alloy and foamed aluminum alloy.

An embodiment of the method for preparing the counter electrode for dye-sensitized solar cell of the present invention is shown in Figure 3. The method for preparing the counter electrode for dye-sensitized solar cell comprises the steps of:
S1. providing an acid-doped polyaniline solution and a conductive substrate 1 (as shown in Figure 1); and
S2. coating the acid-doped polyaniline solution on at least one surface of the conductive substrate 1, and drying to give the counter electrode for dye-sensitized solar cell having an acid-doped polyaniline layer coated on a surface thereof.

In step S1 in the above embodiment of the method for preparing the counter electrode for dye-sensitized solar cell, the mass concentration of the acid-doped polyaniline in the acid-doped polyaniline solution is preferably 1-20%. The process for obtaining the acid-doped polyaniline solution may be as follows:
S11. providing an eigen state polyaniline, an acid and a solvent;
S12. mixing the eigen state polyaniline and the acid, heating in a water bath and/or sonicating, washing, filtering, and drying to give an acid-doped polyaniline precursor; and
S13. dissolving the acid-doped polyaniline precursor in a solvent, and diluting to give the acid-doped polyaniline solution.

Specifically, in step S11 in the above process for obtaining the acid-doped polyaniline solution, the eigen state polyaniline and the acid are mixed in a mass ratio of preferably 1:2-1:5. The eigen state polyaniline may be commercially available. The solvent is preferably at least one of de-ionized water, N-methyl pyrrolidone, methanol, iso-propanol, n-butanol and ethanol. The amount of the solvent used is preferably such that the mass concentration of the final acid-doped polyaniline solution is 1-20%. The acid may be a pure acid liquid, e.g. an analytically pure acid liquid, or an acid solution formulated by diluting a pure acid liquid. The selection of the acid is described hereinbefore, and will not be repeated for conciseness.

In step S12 in the above process for obtaining the acid-doped polyaniline solution, the temperature for heating in a water bath is preferably 50-100°C, and the time is preferably 8-72 h; and the time for sonicating is preferably 4-40 min. Heating in a water bath and/or sonicating are conducted to sufficiently and homogeneously mix the eigen state polyaniline and the acid solution, and accelerate the doping of the acid solution into the eigen state polyaniline. The eigen state polyaniline is not an ideal material for processing due to its poor solubility. Accordingly, its relevant properties can be improved by doping with an acid. For example, a large molecular organic protonic acid may have surface activating effect and act as a surfactant, and may significantly increase the solubility of polyaniline doped therewith. In addition, by doping an organic protonic acid into polyaniline, the intra-molecular and inter-molecular conformations of polyaniline favor the delocalization of the charges in the molecular chain, so that the conductivity of the acid-doped polyaniline is significantly increased. On the other hand, the process of doping with an inorganic protonic acid is simple and the conductivity of the acid-doped polyaniline is relatively high, so that the surface resistance of the obtained electrode is reduced. In this step, washing, filtering and drying are conducted to remove the excessive acid solution, and to obtain a relatively pure acid-doped polyaniline precursor, wherein the drying may be conducting by oven drying, air drying, sun drying, or the like. When oven drying is employed, the temperature is preferably lower than the melting point of the acid-doped polyaniline.

In step S13 in the above process for obtaining the acid-doped polyaniline solution, the acid-doped polyaniline precursor is dissolved and diluted in a solvent to facilitate homogeneous coating of the obtained acid-doped polyaniline solution on a surface of the conductive substrate 1 in a subsequent process.

In step S1 in the above embodiment of the method for preparing the counter electrode for dye-sensitized solar cell, the material for the conductive substrate 1 is preferably one of indium-doped tin oxide glass, fluorine-doped tin oxide glass, carbon steel, stainless steel, aluminum-doped zinc oxide, magnesium-indium oxide, nickel-tungsten oxide, metal nitride, metal selenide, metal sulfides, foamed copper, foamed aluminum, foamed copper alloy and foamed aluminum alloy.

In step S2 in the above embodiment of the method for preparing the counter electrode for dye-sensitized solar cell, the method for coating the acid-doped polyaniline solution on the conductive substrate 1 is preferably spin coating, scrape coating, silkscreen coating, or spray coating. When spin coating is employed for coating the acid-doped polyaniline solution, the rotation speed for the spin coating is preferably 500-4000 rpm, and the time is preferably 15-60 seconds. After the coating is completed, the conductive substrate 1 coated with the acid-doped polyaniline solution is dried, so that the surface of the conductive substrate 1 is tightly bound to the acid-doped polyaniline layer 2 (as shown in Figures 1 and 2). The drying process can be carried out by oven drying, air drying or sun drying. When oven drying is employed, the temperature is preferably above 0°C and less than or equal to 200°C. The above embodiment of the method for preparing the counter electrode for dye-sensitized solar cell may preferably further comprise a step of conducting surface treatment to the conductive substrate 1. The surface treatment conducted to the conductive substrate 1 is preferably one or more of oxygen plasma treatment, uv-ozone treatment, aqua regia treatment, hydrogen peroxide treatment, acid treatment and chemical polishing treatment. The conductive substrate 1 is surface treated to eliminate contaminants and oxides from the surface of the conductive substrate 1, improve wettability and adsorbability of the surface of the conductive substrate 1, and further eliminate organic contaminants from the surface of the conductive glass. This facilitates treatments in subsequent processes, so that the acid-doped polyaniline layer 2 formed in subsequent processes is tightly bound to its surface, so that the electron transfer transmission rate from the counter electrode to the outer circuit as well as the conductivity are further improved.

When the counter electrode for dye-sensitized solar cell of the above embodiment is used in a dye-sensitized solar cell, the materials and the preparation methods of other components of the dye-sensitized solar cell, such as anode base, porous nano-crystalline film, dye sensitizer, and electrolyte, are as follows.

Anode base: indium-doped tin oxide glass, fluorine-doped tin oxide glass, aluminum -doped zinc oxide, magnesium-indium oxide, nickel-tungsten oxide, metal nitride, metal selenide, metal sulfide, or metal base such as stainless steel plate and stainless steel mesh.

Porous nano-crystalline film: TiO₂ porous electrode made from P25 type titanium dioxide particles, or nanometer semi-conductive material such as ZnO, SnO₂ Nb₂O₅ and SrTiO₃; the method for preparing the porous nano-crystalline film may any suitable one, such as scrape coating, silkscreen coating, gelling or spray coating.

Electrolyte: a liquid electrolyte containing 0.5 mol/L KI and 0.05 mol/L I₂, or a polymeric electrolyte.

Dye sensitizer: N719, N3, black dye or some highly effective triphenylamine-type dyes.

The present invention will be further described in detail in combination with specific examples.

### Example 1

A counter electrode for dye-sensitized solar cell has a structure as shown in Figure 1. The counter electrode for dye-sensitized solar cell comprises a conductive substrate 1, and an acid-doped polyaniline layer 2 having a thickness of 20 nm coated on a surface of the conductive substrate 1.

The method for preparing the counter electrode for dye-sensitized solar cell is as follows.

The mass ratio of polyaniline to p-styrene sulfonic acid is 1:3. Eigen state polyaniline is weighed and mixed with a 10 wt% solution of p-styrene sulfonic acid. The mixture is heated in a water bath to 50°C under stirring. After reacting for 72 hours, the mixture is washed with p-styrene sulfonic acid, filtered, and drying to give doped polyaniline. The above acid-doped polyaniline is sufficiently dissolved in de-ionized water to prepare an aqueous solution of polyaniline having a mass fraction of 1% for further use. An indium-doped tin oxide glass is cut into the required size, and sonicated in sequence in a detergent, de-ionized water, acetone, ethanol and iso-propanol, each for 15 min. The washed indium-doped tin oxide glass is subjected to an oxygen plasma treatment for 5-15 min at a power of 10-50 W. In this way, wettability and adsorbability of the surface of the conductive glass are improved and organic contaminants on the surface of the conductive glass are further eliminated. The treated conductive glass is dried for further use. The prepared aqueous solution of polyaniline is added dropwise on a spin coater, and is spin coated on the indium-doped tin oxide glass at a spin speed of 4000 rpm for 15 s. The coated glass is then heating in an oven at 150°C for 40 min. After drying, the desired counter electrode for dye-sensitized solar cell is obtained.

When the counter electrode for dye-sensitized solar cell obtained in Example 1 is used in a dye-sensitized solar cell, the materials and the preparation methods of other components of the dye-sensitized solar cell, such as anode base, porous nano-crystalline film, dye sensitizer, and electrolyte, are as follows.

Anode base: one of indium-doped tin oxide glass, fluorine-doped tin oxide glass, carbon steel, stainless steel, aluminum-doped zinc oxide, magnesium-indium oxide, nickel-tungsten oxide, metal nitride, metal selenide, metal sulfide, foamed copper, foamed aluminum, foamed copper alloy and foamed aluminum alloy, wherein the stainless steel may be a metallic anode base such as stainless steel plate and stainless steel mesh; the thickness thereof may a conventional thickness in the art.

Porous nano-crystalline film: TiO₂ porous electrode made from P25 type titanium dioxide particles; the method for preparing the porous nano-crystalline film may any suitable one, such as scrape coating.

Electrolyte: a liquid electrolyte containing 0.5 M KI and 0.05 M I₂.

Dye sensitizer: N719.

As measured, the counter electrode for dye-sensitized solar cell prepared in Example 1 may advantageously catalyze the redox reaction of I⁻/I₃⁻, increase the probability of redox reaction between I₃⁻ with electrons in the outer circuit, and decrease the probability of the recombination between I₃⁻ and electrons in the conductive band, thereby avoiding its recombination with electrons in the conductive band and increasing to a great extent the photovoltaic performance of the cell. The photoelectric conversion efficiency of the above dye-sensitized solar cell is 5.6%, close to that of the platinum electrode, which is 6% as measured under the same conditions.

### Example 2

A counter electrode for dye-sensitized solar cell has a structure as shown in Figure 1. The counter electrode for dye-sensitized solar cell comprises a conductive substrate 1, and an acid-doped polyaniline layer 2 having a thickness of 50 nm coated on a surface of the conductive substrate 1.

The method for preparing the counter electrode for dye-sensitized solar cell is as follows.

The mass ratio of polyaniline to p-styrene sulfonic acid is 1:5. Eigen state polyaniline is weighed and mixed with a 4 wt% solution of p-styrene sulfonic acid. The mixture is heated in a water bath to 80°C under stirring. After reacting for 18 hours, the mixture is washed with p-styrene sulfonic acid, filtered, and dried to give doped polyaniline. The above acid-doped polyaniline is sufficiently dissolved in de-ionized water to prepare an aqueous solution of polyaniline having a mass fraction of 10% for further use. A fluorine-doped tin oxide glass is cut into the required size, and sonicated in sequence in a detergent, de-ionized water, acetone, ethanol and iso-propanol, each for 15 min. The washed glass is dried for further use. The prepared aqueous solution of polyaniline is added dropwise on a spin coater, and is spin coated on the tin indium oxide glass at a spin speed of 1000 rpm for 30 s. The coated glass is then heating in an oven at 200°C for 30 min. After drying, the desired counter electrode for dye-sensitized solar cell is obtained.

When the counter electrode for dye-sensitized solar cell obtained in Example 2 is used in a dye-sensitized solar cell, the materials and the preparation methods of other components of the dye-sensitized solar cell, such as anode base, porous nano-crystalline film, dye sensitizer, and electrolyte, are as described in Example 1.

As measured, the counter electrode for dye-sensitized solar cell prepared in Example 1 may advantageously catalyze the redox reaction of I⁻/I₃⁻, increase the probability of redox reaction between I₃⁻ with electrons in the outer circuit, and decrease the probability of the recombination between I₃⁻ and electrons in the conductive band, thereby avoiding its recombination with electrons in the conductive band and increasing to a great extent the photovoltaic performance of the cell. The photoelectric conversion efficiency of the above dye-sensitized solar cell is 7.15%, close to that of the platinum electrode, which is 6.9% as measured under the same conditions.

### Example 3

A counter electrode for dye-sensitized solar cell has a structure as shown in Figure 1. The counter electrode for dye-sensitized solar cell comprises a conductive substrate 1, and an acid-doped polyaniline layer 2 having a thickness of 45 nm coated on a surface of the conductive substrate 1.

The method for preparing the counter electrode for dye-sensitized solar cell is as follows.

The mass ratio of polyaniline to p-toluene sulfonic acid is 1:4. Eigen state polyaniline is weighed and mixed with a 4 wt% solution of p-toluene sulfonic acid. The mixture is heated in a water bath to 100°C under stirring. After reacting for 10 hours, the mixture is washed with p-toluene sulfonic acid, filtered, and dried to give doped polyaniline. The above acid-doped polyaniline is sufficiently dissolved in a mixed solvent of de-ionized water and n-butanol in a volume ratio of 1:1 to prepare an aqueous solution of polyaniline having a mass fraction of 1% for further use. A stainless steel base plate is cut into the required size, washed with a detergent, subjected to a chemical polishing treatment to eliminate oxides and contaminants from the surface, sonicated in sequence in de-ionized water, acetone and ethanol, each for 15 min, and dried for further use. The prepared aqueous solution of polyaniline is added dropwise on a spin coater, and is spin coated on the stainless steel plate at a spin speed of 500 rpm for 60 s. The coated plate is then heating in an oven at 100°C for 60 min. After drying, the desired counter electrode for dye-sensitized solar cell is obtained.

When the counter electrode for dye-sensitized solar cell obtained in Example 3 is used in a dye-sensitized solar cell, the materials and the preparation methods of other components of the dye-sensitized solar cell, such as anode base, porous nano-crystalline film, dye sensitizer, and electrolyte, are as described in Example 1.

### Example 4

A counter electrode for dye-sensitized solar cell has a structure as shown in Figure 1. The counter electrode for dye-sensitized solar cell comprises a conductive substrate 1, and an acid-doped polyaniline layer 2 having a thickness of 5 µm coated on a surface of the conductive substrate 1.

The method for preparing the counter electrode for dye-sensitized solar cell is as follows.

The mass ratio of polyaniline to perchloric acid is 1:2. Eigen state polyaniline is weighed and mixed with pure perchloric acid. The mixture is heated in a water bath to 50°C under stirring. After reacting for 72 hours, the mixture is washed with pure perchloric acid, filtered, and dried to give doped polyaniline. The above acid-doped polyaniline is sufficiently dissolved in methanol to prepare an aqueous solution of polyaniline having a mass fraction of 20% for further use. A foamed copper base plate is cut into the required size, washed with a detergent, subjected to a chemical polishing treatment to eliminate oxides and contaminants from the surface, sonicated in sequence in de-ionized water, acetone and ethanol, each for 15 min, and dried for further use. The prepared aqueous solution of polyaniline is coated on the foamed copper base plate by silkscreen printing. The coated base plate is then heating in an oven at 180°C for 40 min. After drying, the desired counter electrode for dye-sensitized solar cell is obtained.

When the counter electrode for dye-sensitized solar cell obtained in Example 4 is used in a dye-sensitized solar cell, the materials and the preparation methods of other components of the dye-sensitized solar cell, such as anode base, porous nano-crystalline film, dye sensitizer, and electrolyte, are as described in Example 1.

### Example 5

A counter electrode for dye-sensitized solar cell has a structure as shown in Figure 1. The counter electrode for dye-sensitized solar cell comprises a conductive substrate 1, and an acid-doped polyaniline layer 2 having a thickness of 20 nm coated on a surface of the conductive substrate 1.

The method for preparing the counter electrode for dye-sensitized solar cell is as follows.

The mass ratio of polyaniline to sulfuric acid is 1:5. Eigen state polyaniline is weighed and mixed with a solution of sulfuric acid. The mixture is sonicated for 40 min. After reacting for 12 hours, the mixture is washed with the solution of sulfuric acid, filtered, and dried to give doped polyaniline. The above acid-doped polyaniline is sufficiently dissolved in iso-propanol to prepare an aqueous solution of polyaniline having a mass fraction of 10% for further use. A foamed copper base plate is cut into the required size, washed with a detergent, treated with diluted hydrochloric acid to eliminate oxides from the surface, sonicated in sequence in de-ionized water, acetone and ethanol, each for 15 min, and dried for further use. The above aqueous solution of polyaniline is added in a spray gun and is spray-coated on the foamed copper base plate to form a polyaniline film having a homogeneous thickness. After the coated base plate is air-dried, the desired counter electrode for dye-sensitized solar cell is obtained.

When the counter electrode for dye-sensitized solar cell obtained in Example 5 is used in a dye-sensitized solar cell, the materials and the preparation methods of other components of the dye-sensitized solar cell, such as anode base, porous nano-crystalline film, dye sensitizer, and electrolyte, are as described in Example 1.

### Example 6

A counter electrode for dye-sensitized solar cell has a structure as shown in Figure 2. The counter electrode for dye-sensitized solar cell comprises a conductive substrate 1, and acid-doped polyaniline layers 2 having a thickness of 20 nm coated on both surfaces of the conductive substrate 1.

The method for preparing the counter electrode for dye-sensitized solar cell is as follows.

The mass ratio of polyaniline to sulfuric acid is 1:3. Eigen state polyaniline is weighed and mixed with a mixture of sulfosalicylic acid and citric acid (mass ratio: 1:1). The mixture is sonicated for 4 min, washed with sulfosalicylic acid, filtered, and dried to give doped polyaniline. The above acid-doped polyaniline is sufficiently dissolved in N-methyl pyrrolidone to prepare an N-methyl pyrrolidone solution of polyaniline having a mass fraction of 15% for further use. A magnesium-indium oxide glass is cut into a plate having an area of 10x20 cm, washed with a detergent, immersed overnight in iso-propanol to sufficiently eliminate residue grease from the surface, sonicated in sequence in de-ionized water, acetone and ethanol, each for 15 min, and dried for further use. The above N-methyl pyrrolidone solution of polyaniline is scrape-coated on two opposite surfaces of the magnesium-indium oxide glass with a glass rod to form a polyaniline film having a homogeneous thickness. The coated glass is cut into the required size and heated in an oven at 100°C for 30 min. After drying, the desired counter electrode for dye-sensitized solar cell is obtained.

When the counter electrode for dye-sensitized solar cell obtained in Example 5 is used in a dye-sensitized solar cell, the materials and the preparation methods of other components of the dye-sensitized solar cell, such as anode base, porous nano-crystalline film, dye sensitizer, and electrolyte, are as described in Example 1.

The counter electrodes for dye-sensitized solar cell prepared in the above Examples 1-6 are tested and verified to have the following properties. The acid-doped polyaniline in the acid-doped polyaniline layer has a relatively high conductivity, leading to low surface resistance of the counter electrode and high conductivity of the counter electrode. The acid-doped polyaniline has a strong catalytic capability, which increases the probability of redox reaction between I₃⁻ in the electrolyte of the dye-sensitized solar cell comprising the counter electrode with electrons in the outer circuit, thereby decreasing to the greatest extent the probability of the recombination between I₃⁻ and electrons in the conductive band. The acid-doped polyaniline has a relatively high viscosity, which increases the binding strength between the acid-doped polyaniline layer and the conductive substrate, thereby further increasing the electron transmission rate from the counter electrode to the outer circuit as well as the conductivity. The counter electrode for dye-sensitized solar cell has a performance which is comparative with that of currently used platinum counter electrodes, and has low production cost. The method for preparing the counter electrode for dye-sensitized solar cell is simple, and the obtained counter electrode for dye-sensitized solar cell has a stable performance. The method exhibits high production efficiency, has low requirements on the production equipments, and is suitable for industrial production.

Described above are only preferred embodiments of the present invention, which are not intended to limit the present invention. All modifications, equivalent substitutions and improvements within the spirit and principle of the present invention shall be within the scope of the present invention.

## Claims

1. A counter electrode for dye-sensitized solar cell, comprising a conductive substrate, **characterized in that** an acid-doped polyaniline layer is coated on at least one surface of the conductive substrate.

2. The counter electrode for dye-sensitized solar cell according to Claim 1, **characterized in that** the acid-doped polyaniline layer has a thickness of 20 nm - 5 µm.

3. The counter electrode for dye-sensitized solar cell according to Claim 1 or 2, **characterized in that** the acid in the acid-doped polyaniline layer is an organic functional protonic acid.

4. The counter electrode for dye-sensitized solar cell according to Claim 1 or 2, **characterized in that** the acid in the acid-doped polyaniline layer is a sulfonic acid and/or citric acid.

5. The counter electrode for dye-sensitized solar cell according to Claim 4, **characterized in that** the sulfonic acid is at least one of camphorsulfonic acid, dodecylsulfonic acid, sulfosalicylic acid, p-styrene sulfonic acid, naphthalenesulfonic acid, dinonylnaphthalenesulfonic acid, dioctyl sulfosuccinate and sulfanilic acid.

6. A method for preparing a counter electrode for dye-sensitized solar cell, comprising the steps of:
providing an acid-doped polyaniline solution and a conductive substrate; and
coating the acid-doped polyaniline solution on at least one surface of the conductive substrate, and drying to give the counter electrode for dye-sensitized solar cell having an acid-doped polyaniline layer coated on a surface thereof.

7. The method for preparing a counter electrode for dye-sensitized solar cell according to Claim 6, **characterized in that** the process for obtaining the acid-doped polyaniline solution comprises:
providing an eigen state polyaniline, an acid and a solvent;
mixing the eigen state polyaniline and the acid, heating in a water bath and/or
sonicating, washing, filtering, and drying to give an acid-doped polyaniline precursor;
and
dissolving the acid-doped polyaniline precursor in a solvent, and diluting to give the acid-doped polyaniline solution.

8. The method for preparing a counter electrode for dye-sensitized solar cell according to Claim 7, **characterized in that**:
the eigen state polyaniline and the acid are mixed in a mass ratio of 1:2-1:5; and
the mass concentration of the acid-doped polyaniline in the acid-doped polyaniline solution is 1-20%.

9. The method for preparing a counter electrode for dye-sensitized solar cell according to Claim 7, **characterized in that**:
the solvent is at least one of de-ionized water, N-methyl pyrrolidone, methanol, iso-propanol, n-butanol and ethanol; and
the acid is at least one of camphorsulfonic acid, dodecylsulfonic acid, sulfosalicylic acid, p-styrene sulfonic acid, naphthalenesulfonic acid, dinonylnaphthalenesulfonic acid, dioctyl sulfosuccinate, sulfanilic acid, citric acid, hydrochloric acid, sulfuric acid and perchloric acid

10. The method for preparing a counter electrode for dye-sensitized solar cell according to Claim 6, **characterized in that**:
the method further comprises conducting surface treatment to the conductive substrate,
wherein the surface treatment conducted to the conductive substrate is at least one of oxygen plasma treatment, uv-ozone treatment, aqua regia treatment, hydrogen peroxide treatment, acid treatment and chemical polishing treatment;
a method for coating the acid-doped polyaniline solution on the conductive substrate is spin coating, scrape coating, silkscreen coating, or spray coating; and
a temperature of the drying is above 0°C and less than or equal to 200°C.
